(19) Europäisches Patentamt

European Patent Office

Office européen des brevets

(11) Veröffentlichungsnummer: **0 581 774 B1**

(12) **EUROPÄISCHE PATENTSCHRIFT**

(45) Veröffentlichungstag der Patentschrift: **02.11.94**

(51) Int. Cl.5: **C23C 14/30**, C23C 14/10, C23C 14/54

(21) Anmeldenummer: **92904217.4**

(22) Anmeldetag: **04.02.92**

(86) Internationale Anmeldenummer: **PCT/EP92/00248**

(87) Internationale Veröffentlichungsnummer: **WO 92/19787 (12.11.92 92/28)**

(54) **VERFAHREN UND EINRICHTUNG ZUM AUFDAMPFEN VON SiOx-SCHICHTEN AUF EIN SUBSTRAT.**

(30) Priorität: **24.04.91 DE 4113364**

(43) Veröffentlichungstag der Anmeldung:
**09.02.94 Patentblatt 94/06**

(45) Bekanntmachung des Hinweises auf die Patenterteilung:
**02.11.94 Patentblatt 94/44**

(84) Benannte Vertragsstaaten:
**DE FR GB IT**

(56) Entgegenhaltungen:
**DE-A- 1 621 244**
**GB-A- 1 144 099**
**US-A- 4 960 607**

**PROC.3. INT. CONF. VAC. WEB COATING, November 01, 1989, San Antonio, Tex., US, pp. 24-49; S. SCHILLER et al.: "POSSIBILITIES OF SILICON OXIDE DEPOSITION IN VACUUM WEB COATING"**

(73) Patentinhaber: **FRAUNHOFER-GESELLSCHAFT ZUR FÖRDERUNG DER ANGEWANDTEN FORSCHUNG E.V.**
**Leonrodstrasse 54**
**D-80636 München (DE)**

(72) Erfinder: **SCHILLER, Siegfried**
**Plattleite 17**
**D-8051 Dresden (DE)**
Erfinder: **NEUMANN, Manfred**
**Schlottwitzer Strasse 5b**
**D-8021 Dresden (DE)**
Erfinder: **ZEISSIG, Gerhard**
**Herbert-Blochwitz-Strasse 10**
**D-8010 Dresden (DE)**
Erfinder: **MORGNER, Henry**
**Am Hofegarten 6**
**D-8017 Dresden (DE)**

(74) Vertreter: **Patentanwälte Grünecker, Kinkeldey, Stockmair & Partner**
**Maximilianstrasse 58**
**D-80538 München (DE)**

## Beschreibung

Die Erfindung betrifft ein Verfahren und eine Einrichtung zum Abscheiden von $SiO_x$-Schichten auf ein Substrat durch Verdampfen von $SiO_2$ unter Verwendung eines Elekronenstrahl-Linienverdampfers mit Magnetfalle, indem der Elektronenstrahl entlang einer geraden Ablenklinie parallel zur Längsachse der Magnetfalle auf dem Verdampfungsgut geführt wird.

Die Erfindung soll ein großflächiges Abscheiden von $SiO_x$-Schichten mit hoher Schichtqualität ermöglichen. Derartige Schichten werden beispielsweise als Barriereschichten zur Verringerung der Gas- und Wasserdampfdurchlässigkeit von Verpackungsmitteln als Schutzschichten zur Erhöhung der Abriebfestigkeit und Korrosionsbeständigkeit, als Interferenzschichten zur Veränderung der Reflexionsbzw. Übertragungseigenschaften für Lichtund Wärmestrahlung oder als elektrische Isolierschichten eingesetzt. Die zu beschichtenden Substrate können vorzugsweise metallische oder nichtmetallische Bänder, Platten oder geringgewölbte Formkörper sein.

Es ist bekannt, $SiO_x$-Schichten mit ausreichender Qualität für die genannten Anwendungen durch reaktive DC-Sputtern von Silizium, durch RF-Sputtern von Siliziumdioxid oder durch plasmagestützte CVD-Abscheidung herzustellen. Die dabei erreichbaren Beschichtungsraten betragen jedoch nur wenige nm/s und reichen damit bei weitem nicht aus, um die für einen breiten Einsatz erforderlichen geringen Beschichtungskosten zu erreichen.

Es ist weiterhin bekannt, $SiO_x$-Schichten durch teilreaktives Verdampfen von SiO herzustellen. Schichten mit akzeptablen Eigenschaften können auch mit diesen Verfahren nur bei relativ geringen Beschichtungsraten erzeugt werden. Bei höheren Raten erhält man gelb gefärbte Schichten mit geringem Oxidationsgrad (x = 1,0...1,5) und unzureichenden Eigenschaften.

Günstigere Eigenschaften sind erreichbar, wenn $SiO_2$ anstelle von SiO verdampft wird. Dadurch wird automatisch ein höherer Oxidationsgrad erreicht und es können unter bestimmten Bedingungen Schichten mit besseren optischen, elektrischen und mechanischen Eigenschaften erzeugt werden. Allerdings kann $SiO_2$ im Gegensatz zu SiO nur mit Hilfe von Elektronenstrahlen effektiv verdampft werden.

Es ist bekannt, durch Verdampfen von $SiO_2$ aus Elektronenstrahl-Kleinflächenverdampfern mit relativ geringen Bedampfungsraten kleinere Flächen, wie Scheinwerferreflektoren oder optische Linsen, zu bedampfen. Auch größere Flächen, wie wärmestrahlenreflektierendes Architekturglas, können durch Anordnung einer Vielzahl solcher Kleinflächenverdampfer bedampft werden, wobei im Interesse der Schichteigenschaften und der Schichtgleichmäßigkeit ebenfalls nur kleine Beschichtungsraten möglich sind.

Es ist auch bekannt, zur Erzielung höherer Beschichtungsraten $SiO_2$ mit sogenannten Elektronenstrahl-Linienverdampfern zu verdampfen (US-A-4 960 607 sowie Schiller, S. et al., Possibilities of Silicon Oxide Deposition in Vacuum Web Coating, Proc. 3. Int. Conf. Vac. Web Coating, San Antonio, Texas, Nov. 1989, S. 24-49). Dabei wird ein Elektronenstrahl längs einer geraden Linie auf der Oberfläche eines rotierenden $SiO_2$-Rohres abgelenkt, das sich über die gesamte Breite des zu beschichtenden Substrates erstreckt. Die Beschichtung erfolgt, indem das Substrat senkrecht zur Ablenkrichtung des Elektronenstrahles mit konstanter Geschwindigkeit über das Verdampfungsgut geführt wird. Um eine Aufheizung und elektrostatische Aufladung des Substrates durch rückgestreute Elektronen zu vermeiden, wird zwischen dem Verdampfungsgut und dem zu beschichtenden Substrat eine Magnetfalle angeordnet. Die Magnetfalle besteht aus einem System von Spulen und Polschuhen, die so angeordnet sind, daß sie über dem Verdampfungsgut ein horizontales Magnetfeld erzeugen. In dieses Magnetfeld wird der in einer Elektronenkanone erzeugte und periodisch abgelenkte Elektronenstrahl eingeschossen und auf das Verdampfungsgut gelenkt. Ebenso werden dabei auch die rückgestreuten Elektronen umgelenkt und vom Substrat ferngehalten (DD-PS 237 526 A1). Auf diese Weise wurden auf Kunststoffolien bei relativ hohen Beschichtungsraten farblostransparente $SiO_x$-Schichten mit einem Oxidationsgrad > 1,5 abgeschieden. Allerdings waren die dabei erreichten Schichteigenschaften immer noch ungünstiger als beim Abscheiden von $SiO_x$-Schichten mit geringeren Beschichtungsraten. Insbesondere die Barriereeigenschaften gegenüber Sauerstoff waren noch unzureichend.

Der Erfindung liegt daher die Aufgabe zugrunde, ein Verfahren und eine Einrichtung zum Aufdampfen von $SiO_x$ mittels eines Elektronenstrahl-Linienverdampfers mit Magnetfalle zu schaffen, mit welchem bei Beschichtungsraten in der Größenordnung von 1000 nm/s Schichteigenschaften erreicht werden, die bisher nur bei Beschichtungsraten in der Größenordnung von wenigen nm/s ermöglicht werden. Insbesondere sollen farblos-transparente $SiO_x$-Schichten auf Kunststoffolien mit hoher Barrierewirkung gegenüber Gasen und Dämpfen erzeugt werden. Durch die hohen Beschichtungsraten und durch Verwendung eines preisgünstigen Verdampfungsgutes sind minimale Beschichtungskosten zu erzielen, die die Anwendungsmöglichkeiten der umweltfreundlichen $SiO_x$-Schichten wesentlich erweitern.

Erfindungsgemäß wird die Aufgabe gemäß Anspruch 1 durch Verdampfen von $SiO_2$ unter Verwendung eines Elektronenstrahl-Linienverdampfers mit Magnetfalle, durch Führung des Elektronenstrahles auf einer geraden, entlang der Längsachse der Magnetfalle verlaufenden Ablenklinie auf dem langgestreckten Verdampfungsgut dadurch gelöst, daß der Elektronenstrahl längs der Ablenklinie sprunghaft abgelenkt wird. Dadurch besteht die Ablenklinie aus einer Reihe von einzelnen Verdampfungspunkten mit extrem hoher Leistungsdichte. Durch diese Veränderung gegenüber der üblichen Betriebsweise von Linienverdampfern wird in der Umgebung der Verdampfungspunkte das verdampfte Material und das vorhandene Gas infolge der hohen Leistungsdichte vermutlich so stark ionisiert, daß damit eine wesentliche Voraussetzung zur Erzielung der gewünschten Schichteigenschaften auch bei hohen Beschichtungsraten geschaffen wird.

Ein weiterer, für das Beschichtungsergebnis wesentlicher Verfahrensparameter ist die Stärke des durch die Magnetfalle des Linienverdampfers erzeugten Magnetfeldes.

Das Magnetfeld wird so eingestellt, daß zwischen dem Verdampfungsgut und dem zu beschichteten Substrat die magnetische Flußdichte einen Maximalwert zwischen 50 und 100 G erreicht. Das Produkt aus Abstand und mittlerer magnetischer Flußdichte zwischen Verdampfungsgut und Substrat muß dabei mindestens $1,5 \times 10^{-3} T \times m$ (15 G x m) betragen, um die gewünschte hohe Schichtqualität, bei gleichzeitig hohen Beschichtungsraten im Bereich von 1000 nm/s zu erreichen. Es wurde gefunden, daß vor allem diese über den bisherigen Einsatz einer Magnetfalle hinaus gehenden Bedingungen die Ursache dafür sind, daß die gewünschten Barriereeigenschaften von ca. 1 $cm^3/m^2 \times d$ auf 12 $\mu m$ Polyesterfolie erreicht werden.

Während der Verdampfung wird in der Bedampfungskammer vorzugsweise ein Totaldruck von zumindest $1 \times 10^{-2}$ Pa, vorzugsweise von 2 bis $5 \times 10^{-2}$ Pa, erzeugt und aufrecht erhalten, wobei vor Beginn der Verdampfung die Bedampfungskammer zunächst auf einen Totaldruck von weniger als $1 \times 10^{-2}$ Pa zu evakuieren ist. Der Totaldruck während der Bedampfung ist durch Abstimmung der Saugleistung der Vakuumpumpen auf die beim Verdampfen durch Dissoziation des $SiO_2$ freigesetzte Sauerstoffmenge einzustellen. Diese Sauerstoffabgabe beträgt bei einer Verdampfungsrate von 1 g/s ca. 3000 Pa x 1/s.

Es ist aber auch möglich, bei einer Strahlleistung von mindestens 50 kW durch eine weitere Erhöhung der Verdampfungsrate und der damit verbundenen Sauerstoffabspaltung oder durch zusätzlichen Sauerstoffeinlaß in die Bedampfungskammer einen Totaldruck zwischen 1 und $3 \times 10^{-1}$ Pa einzustellen.

Unter diesen Bedingungen und in Verbindung mit den anderen Verfahrensmerkmalen zündet zwischen Verdampfertiegel und Substrat ein Plasma, und es können ebenfalls transparent-farblose Schichten mit den genannten guten Barriereeigenschaften abgeschieden werden. Dieses Ergebnis überrascht insofern, als der Fachwelt bisher bekannt ist, daß zur Erzielung entsprechender Schichteigenschaften der Druck in der Verdampferkammer etwa $5 \times 10^{-2}$ Pa nicht überschreiten darf.

Besonders zweckmäßig ist es, das Verdampfungsgut als rotationssymmetrischen Körper, vorzugsweise als Rohr, einzusetzen und während der Beaufschlagung mit dem Elektronenstrahl um die Symmetrieachse zu drehen. Zusätzlich kann diese Drehbewegung noch mit einer periodischen Axialverschiebungdes Körpers bzw. Rohres kombiniert werden, um einen gleichmäßigen Materialabtrag längs der Oberfläche zu erzielen.

Es ist auch möglich, als Verdampfungsgut ebene, vorzugsweise plattenförmige Körper zu verwenden. Dabei wird senkrecht zur Ablenklinie eine periodische Relativbewegung zwischen der Ablenklinie und dem Verdampfungsgut ausgeführt. Das kann sowohl durch periodisches Verschieben der Ablenklinie mit Hilfe elektronenoptischer Mittel als auch durch periodisches Verschieben des Verdampfungsgutes erfolgen. Zusätzlich kann dieser Bewegung noch eine periodische Bewegung des Verdampfungsgutes in Längsrichtung überlagert werden.

Zur Gewährleistung einer hohen Schichtdickengleichmäßigkeit wird die Schichtdickenverteilung der aufgedampften $SiO_x$-Schicht quer zur Transportrichtung des Substrates während des Beschichtungsprozesses ständig gemessen und durch Einflußnahme auf die Verweilzeit des Elektronenstrahles an den einzelnen Verdampfungspunkten in an sich bekannter Weise nachgeregelt. Dieses Nachregeln kann von Hand oder auch durch automatische Regelkreise erfolgen. Die Messung der Schichtdickenverteilung erfolgt, wie üblich, dadurch, daß in Durchlaufrichtung mehrere Schichtdicken-Meßsonden über die Beschichtungsbreite angeordnet sind.

Das erfindungsgemäße Verfahren sowie die erfindungsgemäße Vorrichtung haben den Vorteil, daß mit sehr hohen Verdampfungsraten in der Größenordnung von 1000 nm/s Schichten guter Qualität aus $SiO_x$ aufgebracht werden. Beispielsweise wird die Sauerstoffdurchlässigkeit von 12 $\mu m$-Polyesterfolien von ca. 100 $cm^3/m^2 \times d$ auf 1 $cm^3/m^2 \times d$ reduziert. Derartige Werte wurden bisher nur durch plasmagestützte CVD-Abscheidung von $SiO_x$-Schichten bei wesentlich kleineren Beschichtungsraten erreicht.

Die Einrichtung zur Durchführung des Verfahrens gemäß Anspruch 12 besteht aus einer Elektronenkanone mit dem zugehörigen Ablenksystem für den Elektronenstrahl, die an einen Vakuumrezipienten angeflanscht ist, einem Verdampfungsgut, einer Magnetfalle und einem Transportsystem für die zu beschichtenden Substrate. Erfindungsgemäß sind Halterungen für das Verdampfungsgut vorgesehen, die eine Bewegung des Verdampfungsgutes senkrecht und parallel zur Ablenklinie des Elektronenstrahls während der Verdampfung ermöglichen. Das Verdampfungsmaterial ist vorzugsweise als rotationssymmetrischer Körper ausgebildet, der durch einen Getriebemotor um seine Symmetrieachse drehbar und/oder durch eine Verschiebeeinrichtung in axialer Richtung periodisch verschiebbar ist. Im Interesse einer hohen Materialausnutzung ist es vorteilhaft, als rotationssymmetrischen Verdampfungskörper ein Rohr zu verwenden. Ein Pol der Magnetfalle weist eine Öffnung auf, damit der Elektronenstrahl in das Magnetfeld eingeschossen und auf das Verdampfungsgut umgelenkt werden kann.

Weitere, vorteilhafte Ausgestaltungen des Erfindungsgegenstandes sind in den übrigen Unteransprüchen dargelegt.

An einem Ausführungsbeispiel wird die Erfindung nachstehend näher erläutert. Die zugehörige Zeichnung zeigt eine Einrichtung zur Durchführung des Verfahrens in der Draufsicht.

Der von einer Elektronenkanone 1 erzeugte Elektronenstrahl 2 wird vom Ablenksystem der Elektronenkanone 1 sprunghaft abgelenkt und trifft nach Umlenkung in der Magnetfalle 3 auf die Oberseite eines ca. 1,2 m langen $SiO_2$-Rohres 4 als Verdampfungsgut. Der Elektronenstrahl 2 wird sprunghaft so abgelenkt, daß auf dem $SiO_2$-Rohr 4 mehrere Auftreffpunkte 5 in definiertem Abstand längs einer Ablenklinie 6 entstehen, die als diskrete Verdampfungspunkte wirken.

Damit an diesen Auftreffpunkten 5 keine Krater entstehen, wird das $SiO_2$-Rohr 4 durch einen Getriebemotor 7 in langsame Rotation versetzt und durch eine Verschiebeeinrichtung 8 pro Umdrehung in vorwählbarer Weise axial verschoben, so daß ein gleichmäßiges Abtragen der Oberfläche des $SiO_2$-Rohres 4 erfolgt. Der durch die Dissoziation des $SiO_2$ beim Verdampfen entstehende Sauerstoff und weitere Restgase werden durch den Pumpstutzen 9 abgepumpt. Der Totaldruck und der Sauerstoffpartialdruck in der Verdampfungskammer 10 werden durch Vakuummeßgeräte erfaßt. Für einen zusätzlichen Sauerstoffeinlaß ist ein automatisches Regelventil 11 vorgesehen. Über das $SiO_2$-Rohr 4 und die Magnetfalle 3 wird in bekannter Weise das zu bedampfende Substrat, im Beispiel eine Polyesterfolie (nicht gezeichnet), über eine Kühlwalze geführt. Zwischen den beiden Polen der Magnetfalle 3 wird das zur Durchführung des Verfahrens erforderliche Magnetfeld erzeugt. Dieses Magnetfeld besitzt unmittelbar oberhalb des $SiO_2$-Rohres die für die Funktion der Magnetfalle 3 erforderliche magnetische Flußdichte von $4 \times 10^{-3}$ T bis $5 \times 10^{-3}$ T (40 bis 50 G). Etwa in der Mitte zwischen Verdampfungsgut und Substrat wird durch Zusatzpolschuhe das Magnetfeld verstärkt, so daß sich hier eine maximale Flußdichte von etwa $7 \times 10^{-3}$ T (70 G) ergibt. Unmittelbar unterhalb des zu beschichtenden Substrates beträgt die Flußdichte noch etwa $4 \times 10^{-3}$ T (40 G). Bei einem Abstand von 0,35 m zwischen dem $SiO_2$-Rohr 4 und dem Substrat ergibt sich damit als Produkt aus dem Abstand und dem Mittelwert der magnetischen Flußdichte in diesem Bereich ein Wert von etwa $2 \times 10^{-3}$ T x m (20 G x m).

Die Beschichtung einer Polyesterfolie mit einer farblos-transparenten $SiO_x$-Schicht geringer Sauerstoffdurchlässigkeit bei hoher Beschichtungsrate wird erfindungsgemäß wie folgt ausgeführt.

Die Bedampfungskammer 10 wird zunächst auf etwa $8 \times 10^{-3}$ Pa evakuiert. Danach wird der Elektronenstrahl 2 bei geschlossener Bedampfungsblende und rotierendem $SiO_2$-Rohr 4 nach Sicht auf die Verdampfungspunkte 5 justiert und die Elektronenstrahlleistung auf ca. 60 kW erhöht. Dabei ist eine Verdampfungsrate von etwa 1 g/s zu erwarten, die infolge der Dissoziation des $SiO_2$ zu einer Gasabgabe von ca. 3000 Pa x 1/s zu einem Druckanstieg um ca. $3 \times 10^{-2}$ Pa führt, wenn die Saugleistung an der Bedampfungskammer 10 ca. 100 000 l/s beträgt. Bei dieser Verdampfungsrate und einer Materialausnutzung von 30% ist eine $SiO_x$-Schichtdicke von 100 nm bei einer Bandgeschwindigkeit von ca. 1,5 m/s zu erwarten. Deshalb wird nach erfolgter Strahleinstellung der Bandtransport eingeschaltet und nach Erreichen von ca. 1,5 m/s die Bedampfungsblende geöffnet. Aufgrund der Anzeige der nach der Kühlwalze angeordneten Schichtdickenmeßeinrichtung wird die Verweilzeit des Elektronenstrahles 2 an den einzelnen Verdampfungspunkten in der Weise verändert, daß die Schichtdickenverteilung über die Bandbreite ausreichend konstant ist. Falls nun die mittlere Schichtdicke vom gewünschten Wert abweicht, wird die Bandgeschwindigkeit entsprechend verändert. Diese Einstellungen können durch entsprechende Regelkreise automatisiert werden.

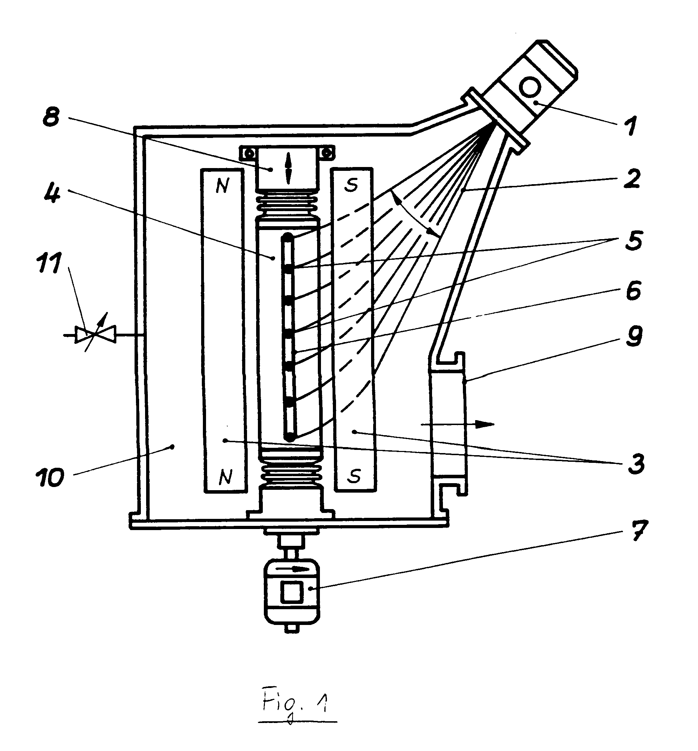

**Patentansprüche**

1. Verfahren zum Aufdampfen von $SiO_x$-Schichten auf ein Substrat durch Verdampfen von $SiO_2$ unter Verwendung eines Elektronenstrahl-Linienverdampfers mit Magnetfalle, indem der Elektronenstrahl entlang einer Ablenklinie parallel zur Längsachse der Magnetfalle auf dem Verdampfungsgut geführt wird, **dadurch gekennzeichnet,** daß der Elektronenstrahl (2) entlang der Ablenklinie sprunghaft abgelenkt wird, derart, daß eine Reihe von Verdampfungspunkten (5) hoher Leistungsdichte entsteht, wobei das Magnetfeld der Magnetfalle (3) so eingestellt wird, daß zwischen dem Verdampfungsgut (4) und dem zu beschichtenden Substrat ein Maximalwert der magnetischen Flußdichte von $5 \times 10^{-3}$ bis $1 \times 10^{-2}$ T (50 bis 100 G) erreicht wird und das Produkt aus dem Abstand und der mittleren magnetischen Flußdichte zwischen dem Verdampfungsgut (4) und dem Substrat zumindest $1,5 \times 10^{-3}$ T x m (15 G x m) beträgt.

2.  Verfahren nach Anspruch 1, **dadurch gekennzeichnet,** daß während der Verdampfung der Totaldruck in der Verdampfungskammer (10) durch Abstimmung der Saugleistung der Vakuumpumpen auf die beim Verdampfen freigesetzte Sauerstoffmenge auf 2 bis $5 \times 10^{-2}$ Pa eingestellt wird, nachdem vor Beginn der Verdampfung zumindest auf einen Druck von $1 \times 10^{-2}$ Pa evakuiert wurde.

3.  Verfahren nach Anspruch 1, **dadurch gekennzeichnet,** daß der Totaldruck während der Verdampfung durch Abstimmung der Saugleistung der Vakuumpumpen auf die beim Verdampfen freigesetzte Sauerstoffmenge auf 1 bis $3 \times 10^{-1}$ Pa eingestellt und ein Plasma gezündet wird, indem bei einer Elektronenstrahlleistung von zumindest 50 kW die Verdampfungsrate und, damit verbunden, die Sauerstoffabspaltung erhöht werden.

4.  Verfahren nach Anspruch 3, **dadurch gekennzeichnet,** daß zur Erhöhung des Totaldruckes auf 1 bis $3 \times 10^{-1}$ Pa zusätzlich Sauerstoff in die Verdampfungskammer (10) eingelassen wird.

5.  Verfahren nach zumindest einem der vorhergehenden Ansprüche 1 bis 4, **dadurch gekennzeichnet,** daß als Verdampfungsgut ein rotationssymmetrischer Körper, vorzugsweise ein Rohr (4), eingesetzt wird und dieser während der Beaufschlagung durch den Elektronenstrahl um die Symmetrieachse gedreht wird.

6.  Verfahren nach Anspruch 5, **dadurch gekennzeichnet,** daß der rotationssymmetrische Körper zusätzlich zur Rotation auch axial periodisch bewegt wird.

7.  Verfahren nach zumindest einem der vorhergehenden Ansprüche 1 bis 6, **dadurch gekenn-**

**zeichnet, daß** als Verdampfungsgut ein ebener Körper eingesetzt wird und zwischen diesem und der Ablenklinie des Elektronenstrahles während der Beaufschlagung durch den Elektronenstrahl periodisch eine Relativbewegung senkrecht zur Längsausdehnung der Ablenklinie ausgeführt wird.

8.  Verfahren nach Anspruch 7, **dadurch gekennzeichnet,** daß das Verdampfungsgut zusätzlich eine periodische Bewegung in Richtung der Ablenklinie des Elektronenstrahles ausführt.

9.  Verfahren nach zumindest einem der vorhergehenden Ansprüche 1 bis 8, **dadurch gekennzeichnet,** daß die Schichtdickenverteilung der $SiO_x$-Schicht über die Beschichtungsbreite des Substrates während des Aufdampfens kontinuierlich kontrolliert gemessen und durch Regelung der Verweilzeit des Elektronenstrahles (2) an den einzelnen Verdampfungspunkten (5) konstant gehalten wird.

10. Verfahren nach zumindest einem der vorhergehenden Ansprüche 1 bis 9, **dadurch gekennzeichnet,** daß die Schichtdickenverteilung der $SiO_x$-Schicht in Transportrichtung des Substrats während des Aufdampfens kontinuierlich gemessen und durch Regelung der Transportgeschwindigkeit des Substrates konstant gehalten wird.

11. Verfahren nach Anspruch 9 und 10, **dadurch gekennzeichnet,** daß eine Schichtdickenmeßeinrichtung, eine Steuervorrichtung für die Transportgeschwindigkeit des Substrats und eine Steuereinrichtung für die Verweilzeit des Elektronenstrahles in einem Regelkreis miteinander verbunden sind.

12. Einrichtung zum Aufdampfen von $SiO_x$-Schichten auf ein Substrat mittels Elektronenstrahl-Linienverdampfer, bestehend aus einer an einem Vakuumrezipienten angeflanschten Elektronenkanone mit Ablenksystem, dem Verdampfungsgut, einer Magnetfalle und einem Transportsystem für die Substrate, insbesondere zur Durchführung des Verfahrens nach Anspruch 1, **dadurch gekennzeichnet,** daß Halterungen für das Verdampfungsgut (4) angeordnet sind, die während der Verdampfung eine Bewegung des Verdampfungsgutes (4) senkrecht und in Richtung der Ablenklinie des Elektronenstrahls (2) ermöglichen.

13. Einrichtung nach Anspruch 12, **dadurch gekennzeichnet,** daß das Verdampfungsgut ein rotationssymmetrischer Körper (4) ist, der durch einen Getriebemotor (7) um seine Symmetrieachse drehbar und durch eine Verschiebeeinrichtung (8) in axialer Richtung periodisch verschiebbar ist.

14. Einrichtung nach Anspruch 12 oder 13, **dadurch gekennzeichnet,** daß das Verdampfungsgut ein Rohr (4) ist.

**Claims**

1. Method of vapour-depositing $SiO_x$ layers onto a substrate by evaporating $SiO_2$ using an electron-beam line evaporator with a magnetic trap, in that the electron beam is guided along a deflection line parallel to the longitudinal axis of the magnetic trap on the evaporation material, **characterized in that** the electron beam (2) along the deflection line is suddenly deflected in such a way as to produce a row of evaporation points (5) of high power density, with the magnetic field of the magnetic trap (3) being adjusted in such a way that a maximum value of the magnetic flux density of $5 \times 10^{-3}$ to $1 \times 10^{-2}$ T (50 to 100 G) is achieved between the evaporation material (4) and the substrate to be coated and the product of the clearance and the mean magnetic flux density between the evaporation material (4) and the substrate is at least $1.5 \times 10^{-3}$ T x m (15 G x m).

2. Method according to claim 1, **characterized in that** in the course of evaporation the total pressure in the evaporation chamber (10) is adjusted, by tuning the intake capacity of the vacuum pumps to the oxygen quantity liberated during evaporation, to 2 to $5 \times 10^{-2}$ Pa, after an evacuation at least to a pressure of $1 \times 10^{-2}$ Pa has been effected prior to the start of evaporation.

3. Method according to claim 1, **characterized in that** the total pressure in the course of evaporation is adjusted, by tuning the intake capacity of the vacuum pumps to the oxygen quantity liberated during evaporation, to 1 to $3 \times 10^{-1}$ Pa and a plasma is ignited in that, at an electron-beam output of at least 50 kW, the evaporation rate and consequently the oxygen release are increased.

4. Method according to claim 3, **characterized in that** additional oxygen is admitted into the evaporation chamber in order to increase the total pressure to 1 to $3 \times 10^{-1}$ Pa.

5. Method according to at least one of the preceding claims 1 to 4, **characterized in that** a rotationally symmetric body, preferably a tube (4), is used as an evaporation material and said tube while being acted upon by the electron beam is rotated about the axis of symmetry.

6. Method according to claim 5, **characterized in that** the rotationally symmetric body, in addition to the rotation, is also axially periodically moved.

7. Method according to at least one of the preceding claims 1 to 6, **characterized in that** a plane body is used as an evaporation material and between said body and the deflection line of the electron beam in the course of the action of the electron beam a relative movement is periodically executed at right angles to the longitudinal extension of the deflection line.

8. Method according to claim 7, **characterized in that** the evaporation material additionally executes a periodic movement in the direction of the deflection line of the electron beam.

9. Method according to at least one of the preceding claims 1 to 8, **characterized in that** in the course of vapour deposition the layer thickness distribution of the $SiO_x$ layer over the coating width of the substrate is continuously monitored and measured and held constant by regulating the dwell time of the electron beam (2) at the individual evaporation points (5).

10. Method according to at least one of the preceding claims 1 to 9, **characterized in that** in the course of vapour deposition the layer thickness distribution of the $SiO_x$ layer in the transport direction of the substrate is continuously measured and held constant by regulating the transport speed of the substrate.

11. Method according to claim 9 and 10, **characterized in that** a layer thickness measuring device, a control apparatus for the transport speed of the substrate and a control device for the dwell time of the electron beam are connected to one another in a control loop.

12. Device for vapour-depositing $SiO_x$ layers onto a substrate by means of an electron-beam line evaporator, comprising an electron gun with a deflection system flange-mounted on a vacuum recipient, the evaporation material, a magnetic trap and a transport system for the substrates, in particular for effecting the method according to claim 1, **characterized in that** holding devices for the evaporation material (4) are disposed which, in the course of evaporation, enable a movement of the evaporation material (4) at right angles to and in the direction of the deflection line of the electron beam (2).

13. Device according to claim 12, **characterized in that** the evaporation material is a rotationally symmetric body (4) which is rotatable about its axis of symmetry by means of a geared motor (7) and is periodically displaceable in an axial direction by means of a displacement device (8).

14. Device according to claim 12 or 13, **characterized in that** the evaporation material is a tube (4).

**Revendications**

1. Procédé pour déposer par évaporation des couches de $SiO_x$ sur un substrat par évaporation de $SiO_2$ au moyen d'un évaporateur linéaire à faisceau électronique avec un piège magnétique, en guidant le faisceau électronique le long d'une ligne de déviation parallèlement à l'axe longitudinal du piège magnétique, sur le produit à évaporer, **caractérisé** par le fait que le faisceau électronique (2) est dévié brusquement le long de la ligne de déviation de sorte que l'on obtient une série de points d'évaporation (5) de grande densité de puissance, le champ magnétique du piège magnétique (3) étant réglé de manière à obtenir entre le produit à évaporer (4) et le substrat à recouvrir, une valeur maximale de la densité de flux magnétique comprise entre $5 \times 10^{-3}$ et $1 \times 10^{-2}$ T (50 à 100 G) et à ce que le produit de l'écartement par la densité moyenne du flux magnétique entre le produit à évaporer (4) et le substrat soit au moins égal à $1,5 \times 10^{-3}$ T x m (15 G x m).

2. Procédé selon la revendication 1, **caractérisé** par le fait que pendant l'évaporation, la pression totale dans la chambre d'évaporation (10) est réglée à une valeur comprise entre 2 et 5 x $10^{-2}$ Pa par ajustement de la puissance d'aspiration des pompes à vide sur la quantité d'oxygène libérée lors de l'évaporation après avoir fait le vide au moins à une pression de $1 \times 10^{-2}$ Pa avant le début de l'évaporation.

3. Procédé selon la revendication 1, **caractérisé** par le fait que la pression totale est réglée pendant l'évaporation à une valeur comprise entre 1 et $3 \times 10^{-1}$ Pa par ajustement de la puissance d'aspiration des pompes à vide sur la quantité d'oxygène libérée lors de l'évaporation et qu'un plasma est amorcé en augmentant le taux d'évaporation et partant, la libération d'oxygène, pour une puissance du faisceau électronique d'au moins 50 kW.

4. Procédé selon la revendication 3, **caractérisé** par le fait que pour augmenter la pression totale à une valeur comprise entre 1 et 3 x $10^{-1}$ Pa, on fait entrer de l'oxygène supplémentaire dans la chambre d'évaporation (10).

5. Procédé selon au moins l'une des revendications 1 à 4, **caractérisé** par le fait que l'on utilise comme produit à évaporer un corps à symétrie de révolution, de préférence un tube (4) et que l'on fait tourner ce dernier autour de l'axe de symétrie pendant l'alimentation par le faisceau électronique.

6. Procédé selon la revendication 5, **caractérisé** par le fait qu'en plus de la rotation, le corps à symétrie de révolution subit également un déplacement axial périodique.

7. Procédé selon au moins l'une des revendications 1 à 6, **caractérisé** par le fait que l'on utilise comme produit à évaporer, un corps plat et qu'entre celui-ci et la ligne de déviation du faisceau électronique on effectue périodiquement un déplacement relatif, perpendiculairement au prolongement longitudinal de la ligne de déviation, pendant l'alimentation par le faisceau électronique.

8. Procédé selon la revendication 7, **caractérisé** par le fait que le produit à évaporer exécute de plus un déplacement périodique en direction de la ligne de déviation du faisceau électronique.

9. Procédé selon au moins l'une des revendications 1 à 8, **caractérisé** par le fait que la répartition de l'épaisseur de la couche de $SiO_x$ sur la largeur du substrat à recouvrir est mesurée et contrôlée en continu pendant le dépôt par évaporation sous vide et est maintenue constante par un réglage de la durée d'action du faisceau électronique (2) sur les différents points d'évaporation (5).

10. Procédé selon au moins l'une des revendications 1 à 9, **caractérisé** par le fait que la répartition de l'épaisseur de la couche de $SiO_x$ dans la direction de transport du substrat est mesurée en continu pendant le dépôt par évaporation sous vide et est maintenue constante par un réglage de la vitesse de transport du substrat.

11. Procédé selon les revendications 9 et 10, **caractérisé** par le fait qu'un dispositif de mesure d'épaisseur de couche, un dispositif de commande de la vitesse de transport du substrat et un dispositif de commande du temps d'action du faisceau électronique sont reliés entre eux dans un circuit de réglage.

12. Dispositif pour déposer par évaporation sous vide des couches de $SiO_x$ sur un substrat au moyen d'un évaporateur linéaire à faisceau électronique, constitué par un canon électronique raccordé par brides sur un récipient à vide et équipé d'un système de déviation, le produit à évaporer, un piège magnétique et un système de transport des substrats, notamment pour mettre en oeuvre le procédé selon la revendication 1, **caractérisé** par le fait qu'il est prévu des moyens de maintien du produit à évaporer (4), lesquels moyens permettent pendant l'évaporation, un déplacement du produit à évaporer (4) perpendiculairement à et dans la direction de la ligne de déviation du faisceau électronique (2).

13. Dispositif selon la revendication 12, **caractérisé** par le fait que le produit à évaporer est un corps (4) à symétrie de révolution qui peut être entraîné en rotation autour de son axe de symétrie par un motoréducteur (7) et peut être déplacé périodiquement dans la direction axiale par un dispositif de déplacement (8).

14. Dispositif selon la revendication 12 ou 13, **caractérisé** par le fait que le produit à évaporer est un tube (4).

Fig. 1